(19) Europäisches Patentamt
European Patent Office
Office européen des brevets

(11) **EP 4 020 805 A1**

(12) **EUROPEAN PATENT APPLICATION**

(43) Date of publication:
**29.06.2022 Bulletin 2022/26**

(21) Application number: **21216525.2**

(22) Date of filing: **21.12.2021**

(51) International Patent Classification (IPC):
**H03H 17/06** (2006.01) **H03H 17/02** (2006.01)
**G01R 33/565** (2006.01)

(52) Cooperative Patent Classification (CPC):
**H03H 17/06; G01R 33/56518; H03H 17/0227**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**KH MA MD TN**

(30) Priority: **25.12.2020 JP 2020216316**
**07.12.2021 JP 2021198574**

(71) Applicant: **Canon Medical Systems Corporation Otawara-shi, Tochigi 324-0036 (JP)**

(72) Inventor: **TAKESHIMA, Hidenori**
**324-0036 Tochigi (JP)**

(74) Representative: **Moreland, David**
**Marks & Clerk LLP**
**The Beacon**
**176 St Vincent Street**
**Glasgow G2 5SG (GB)**

(54) **SIGNAL PROCESSING APPARATUS, MAGNETIC RESONANCE IMAGING APPARATUS, AND SIGNAL PROCESSING METHOD**

(57) A signal processing apparatus (1) according to the present embodiment computes a first integral value corresponding to an element in a coefficient sequence of a first input sequence and a second integral value corresponding to the element in a coefficient sequence of a second input sequence next to the first input sequence, and includes an integral value computing unit (151). The integral value computing unit adds a value not overlapping the first input sequence in the second input sequence to the first integral value and subtracts a value not overlapping the second input sequence in the first input sequence from the first integral value for the element, thereby computing the second integral value.

FIG.5

EP 4 020 805 A1

**EP 4 020 805 A1**

## Description

FIELD

Embodiments described herein relate generally to a signal processing apparatus, a magnetic resonance imaging apparatus, and a signal processing method.

BACKGROUND

It has conventionally been difficult to put a finite impulse response (FIR) digital filter having a great number of taps to practical use.

SUMMARY OF THE INVENTION

A signal processing apparatus configured to compute a first integral value corresponding to an element in a coefficient sequence of a first input sequence and a second integral value corresponding to the element in a coefficient sequence of a second input sequence next to the first input sequence, the signal processing apparatus includes an integral value computing unit configured to add a value not overlapping the first input sequence in the second input sequence to the first integral value and subtract a value not overlapping the second input sequence in the first input sequence from the first integral value for the element, thereby computing the second integral value.

The signal processing apparatus may further include a signal value computing unit configured to compute an output signal value corresponding to the second input sequence based on the second integral value and the coefficient sequence of the second input sequence.

The signal processing apparatus may be configured to compute a third integral value corresponding to the element in a coefficient sequence of a third input sequence next to the second input sequence, wherein the integral value computing unit may be configured to add a value not overlapping the second input sequence in the third input sequence to the second integral value and subtract a value not overlapping the third input sequence in the second input sequence from the second integral value for the element, thereby computing the third integral value, and the signal value computing unit may be configured to compute an output signal value corresponding to the third input sequence based on the third integral value and the coefficient sequence of the third input sequence.

The coefficient sequence may correspond to a sequence of a series of amplification factors corresponding to an input sequence.

The integral value computing unit and the signal value computing unit may constitute a finite impulse response digital filter.

The element may be a representative coefficient representing a plurality of filter coefficients included in a range defined by values of the filter coefficients, and the coefficient sequence may be a series of the representative coefficients.

The number of bits in the filter coefficients, the representative coefficient, the first integral value, and the second integral value may be larger than number of bits of the first input sequence and the second input sequence.

The number of bits in the filter coefficients, the representative coefficient, the first integral value, and the second integral value may be larger than 32.

The range may be set by comparing an arithmetic result using the filter coefficients with a threshold or comparing the filter coefficients with a threshold.

A magnetic resonance imaging apparatus includes: the signal processing apparatus, wherein the signal value computing unit may be configured to use a signal value for controlling an electric current to be supplied to a gradient coil in a pulse sequence as the input sequence, and may be configured to output a position in a k-space as the output signal value, and the magnetic resonance imaging apparatus further includes an adjusting unit may be configured to correct a position in the k-space of magnetic resonance data generated by performing the pulse sequence or modify the pulse sequence based on the position in the k-space.

The non-overlapping may correspond to delay in the input sequence.

The signal processing apparatus may further include a storage unit configured to store therein a partial filter coefficient sequence composed of a plurality of filter coefficients arrayed in order of filter indices for distinguishing the respective filter coefficients belonging to each of a plurality of ranges of the amplification factor for the input signal input to the finite impulse response filter in units of a set index for distinguishing a set of the filter indices; a range determining unit configured to determine the range of the amplification factor of the filter coefficients determined to be included in the set of the filter indices based on the partial filter coefficient sequence corresponding to the set of the filter indices; and a representative coefficient determining unit configured to determine the representative coefficient representing the filter coefficients for each of the ranges of the amplification factor.

The representative coefficient determining unit may be configured to compute an average of the filter coefficients

2

for each of the ranges of the amplification factor, thereby determining the representative coefficient.

The number of bits in the filter coefficients and the representative coefficient may be larger than 32.

In computing the second integral value, the signal processing apparatus may compute the second integral value using the first integral value without re-computing the first integral value.

A signal processing method includes: computing a first integral value corresponding to an element in a coefficient sequence of a first input sequence; adding a value not overlapping the first input sequence in a second input sequence, which is next to the first input sequence, to the first integral value and subtracting a value not overlapping the second input sequence in the first input sequence from the first integral value for the element, thereby computing a second integral value corresponding to the element in a coefficient sequence of the second input sequence.

A signal processing apparatus is configured to compute a first integral value corresponding to an element in a coefficient sequence of a first input sequence and a second integral value corresponding to the element in a coefficient sequence of a second input sequence next to the first input sequence, in which the element is a representative coefficient representing a plurality of filter coefficients included in a range defined by values of the filter coefficients, and the coefficient sequence is a series of the representative coefficients, the signal processing apparatus includes an integral value computing unit configured to compute the second integral value for the element based on the first integral value and the second input sequence.

A signal processing apparatus for an magnetic resonance imaging apparatus, the signal processing apparatus is configured to receive an input which is a signal value for controlling an electric current to be supplied to a gradient coil in a pulse sequence as the input sequence, and output a position in a k-space as the output signal value, the signal processing apparatus being configured to compute a first integral value from the received input, the first integral value corresponding to an element in a coefficient sequence of a first input sequence and a second integral value corresponding to the element in a coefficient sequence of a second input sequence next to the first input sequence, the signal processing apparatus being configured to derive a position in k-space from the first integral value and a position in k-space for the second integral value, the signal processing apparatus comprise: an integral value computing unit configured to add a value not overlapping the first input sequence in the second input sequence to the first integral value and subtract a value not overlapping the second input sequence in the first input sequence from the first integral value for the element, thereby computing the second integral value.

BRIEF DESCRIPTION OF THE DRAWINGS

FIG. 1 is a block diagram of an example of a signal processing apparatus according to a first embodiment;
FIG. 2 is a diagram for explaining various terms according to the first embodiment;
FIG. 3 is a diagram for explaining various terms according to the first embodiment;
FIG. 4 is a flowchart of an example of a process of parameter determination according to the first embodiment;
FIG. 5 is a diagram of an example of representative coefficients computed from partial filter coefficient sequences for respective filter index sets;
FIG. 6 is a diagram of an example of a graph indicating an output signal (dotted line) in actual measurement and an output signal (dotted line) based on the representative coefficient and an example of representative coefficient and duration length according to the first embodiment;
FIG. 7 is a flowchart of an example of a process of filter arithmetic processing according to the first embodiment;
FIG. 8 is a diagram of an example of a prior integration interval according to the first embodiment;
FIG. 9 is a diagram of an example of the prior integration interval, a next integration interval, and an outline of computation performed on the next integration interval according to the first embodiment;
FIG. 10 is a block diagram of an example of a magnetic resonance imaging apparatus according to a second embodiment;
FIG. 11 is a flowchart of an example of a process of adjustment according to the second embodiment; and
FIG. 12 is a diagram of an example of a graph of a gradient system transfer function and an example of the sum of input signals in $D_m$ and duration length according to an application example of the second embodiment.

DETAILED DESCRIPTION

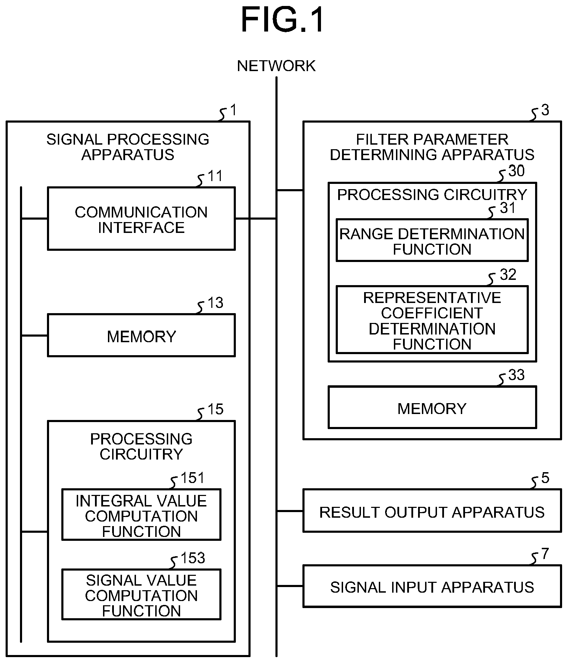

Exemplary embodiments of a signal processing apparatus, a magnetic resonance imaging apparatus, a signal processing method, and a signal processing program are described below in greater detail with reference to the accompanying drawings. FIG. 1 is a block diagram of an example of a signal processing apparatus 1. Technical ideas according to the embodiments are not necessarily embodied by the configuration illustrated in FIG. 1 and may be embodied by hardware, such as electric circuitry including various circuitry elements.

First embodiment

The signal processing apparatus 1 includes a communication interface 11, a memory 13, and processing circuitry 15. The signal processing apparatus 1 functions as a filter arithmetic apparatus including a digital filter that performs a finite impulse response (FIR) arithmetic operation on input signals (hereinafter, referred to as an FIR filter), for example. As illustrated in FIG. 1, the communication interface 11, the memory 13, and the processing circuitry 15 are electrically coupled by a bus in the signal processing apparatus 1. As illustrated in FIG. 1, the signal processing apparatus 1 is coupled to a network via the communication interface 11.

The network illustrated in FIG. 1 is coupled to a filter parameter determining apparatus 3, a result output apparatus 5, and a signal input apparatus 7, for example. The result output apparatus 5 is an apparatus to which processing results of the FIR filter in the signal processing apparatus 1 are output. The signal input apparatus 7 is an apparatus that receives input signals to be input to the FIR filter in the signal processing apparatus 1.

The filter parameter determining apparatus 3 includes a memory 33 and processing circuitry 30. The memory 33 is provided as storage circuitry that stores therein various kinds of information. The memory 33 is a storage apparatus, such as a hard disk drive (HDD), a solid state drive (SSD), and an integrated circuit storage device. The memory 33 is not limited to an HDD or an SSD and may be a semiconductor memory element, such as a random access memory (RAM) and a flash memory, an optical disc, such as a compact disc (CD) and a digital versatile disc (DVD), or a drive apparatus that reads and writes various kinds of information from and to a portable storage medium and a semiconductor memory element, such as a RAM.

The memory 33 in the filter parameter determining apparatus 3 stores therein partial filter coefficient sequences corresponding to respective filter index sets.

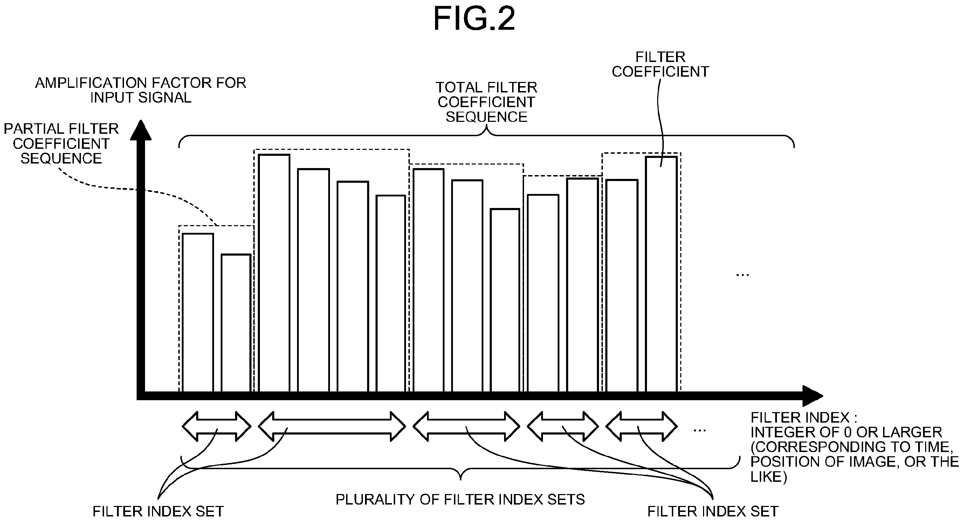

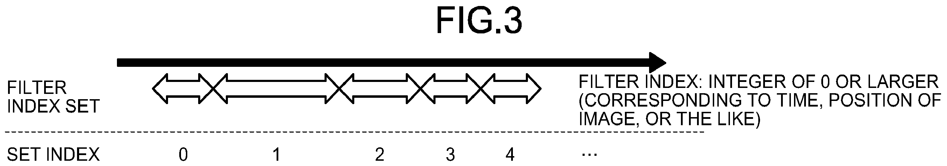

The following describes definition of a filter index, a filter index set, a total filter coefficient sequence, a partial filter coefficient sequence, and a plurality of filter index sets with reference to FIG. 2 and FIG. 3.

FIG. 2 is a diagram for explaining definition of a filter index set, a total filter coefficient sequence, a partial filter coefficient sequence, and a plurality of filter index sets. A filter index in the FIR filter is distinguished by an index (hereinafter, referred to as a filter index). The filter index is an integer of 0 or larger indicating the number of stages for shifting input signals to be input to the FIR filter and corresponds to time and the position of an image, for example. The filter index may be the number of stages of delay in input signals to be input to the FIR filter. In the graph illustrated in FIG. 2, the horizontal axis is a time axis or a direction having properties similar to those of the time axis (hereinafter, referred to as a pseudo time-axis direction). The vertical axis is a direction indicating the magnitude of the filter coefficient, that is, a direction indicating the amplification factor for the input signals (hereinafter, referred to as an amplification factor axis direction). In FIG. 2, the filter coefficient is represented by a bar-like rectangle having the length corresponding to the amplification factor for the input signals and disposed at the position corresponding to the filter index.

As illustrated in FIG. 2, the filter coefficient sequence is a sequence of filter coefficients associated with the respective filter indices. The total filter coefficient sequence is a sequence of filter coefficients in order of the filter indices from 0 to (the degree of filters - 1). The partial filter coefficient sequence is a partial filter coefficient sequence associated with consecutive filter indices in the total filter coefficient sequence. In FIG. 2, the partial filter coefficient sequences are each composed of a series of filter coefficients in a dotted rectangle. The filter index set is a set of a series of filter indices corresponding to the partial filter coefficient sequence. The filter index set includes the filter indices of a plurality of filter coefficients in the partial filter coefficient sequence as elements. In FIG. 2, the filter index set is represented by a double-pointed arrow positioned under the partial filter coefficient sequence represented by a dotted rectangle. The filter index set corresponds to an interval for extracting the partial filter coefficient sequence from the total filter coefficient sequence. A plurality of filter index sets are each distinguished by an index for distinguishing the filter index set (hereinafter, referred to as a set index). As illustrated in FIG. 3, the filter index sets are associated with respective set indices. As illustrated in FIG. 2, the index corresponding to a set of filter index sets is a set index set. The set index set includes the set indices as elements.

The memory 33 corresponds to a storage unit in the filter parameter determining apparatus 3. The total of filter indices included in a plurality of filter index sets corresponds to a large number of taps, such as 1,000,000 or 3,000,000 taps. The partial filter coefficient sequence stored in the memory 33 is part of the total filter coefficient sequence acquired by measurement using a filter coefficient acquiring apparatus, for example. Alternatively, the partial filter coefficient sequence is part of a coefficient sequence generated by the filter coefficient acquiring apparatus using filter parameters supplied by a filter designer and a user, for example. Measurement of the filter coefficient and generation of the filter coefficient sequence using the filter coefficient acquiring apparatus are not explained herein because they can be performed using various known technologies.

The processing circuitry 30 in the filter parameter determining apparatus 3 collectively controls the filter parameter determining apparatus 3. The processing circuitry 30 includes a range determination function 31 and a representative coefficient determination function 32 relating to determination of filter parameters used for computation in the FIR filter in the signal processing apparatus 1, for example. The processing circuitry 30 that implements the range determination function 31 and the representative coefficient determination function 32 corresponds to a range determining unit and a representative coefficient determining unit. The range determination function 31, the representative coefficient determination function 32, and other functions are stored in the memory 33 as computer-executable programs. The processing circuitry 30 is a processor. The processing circuitry 30, for example, reads out a computer program from the memory 33 and executes it, thereby implementing the function corresponding to the computer program. In other words, the processing circuitry 30 that has read out the computer programs has the range determination function 31 and the representative coefficient determination function 32. The filter parameters, the range determination function 31, and the representative coefficient determination function 32 will be described later.

While the "processor" reads out the computer programs corresponding to the respective functions from the memory and executes them in the description above, the embodiment is not limited thereto. The term "processor" means circuitry, such as a CPU, a graphics processing unit (GPU), an application specific integrated circuit (ASIC), a programmable logic device (e.g., a simple programmable logic device (SPLD)), a complex programmable logic device (CPLD), and a field programmable gate array (FPGA).

If the processor is a CPU, for example, the processor reads out a computer program stored in the memory and executes it, thereby implementing the corresponding function. If the processor is an ASIC, the computer program is not stored in the memory, and the function is directly incorporated in circuitry of the processor as a logic circuit. The processors according to the present embodiment are not necessarily each provided as single circuitry. Alternatively, a plurality of independent circuitry may be combined to serve as one processor and implement the functions. While the computer programs corresponding to the range determination function 31 and the representative coefficient determination function 32 are stored in single storage circuitry in the description above, the embodiment is not limited thereto. A plurality of storage circuitry may be dispersed and disposed, and the processing circuitry may read out a computer program from the corresponding storage circuitry.

The processing circuitry 30 acquires partial filter coefficient sequences corresponding to the respective filter index sets in the FIR filter and extracted from the total filter coefficient sequence from the filter coefficient acquiring apparatus. The processing circuitry 30 stores the partial filter coefficient sequences in the memory 33. Based on the partial filter coefficient sequence corresponding to the filter index set being processed in the FIR filter, the range determination function 31 of the processing circuitry 30 determines the range of the amplification factor determined to be included in the filter index set. The range determination function 31 performs the range determination described above on all the filter index sets, thereby determining the ranges of the amplification factor for the respective filter index sets having a smaller number of elements than the number of elements of the total filer coefficient sequence. Based on a plurality of filter coefficients belonging to each of the ranges of the amplification factor, the representative coefficient determination function 32 determines a representative coefficient representing the filter coefficients in each of the ranges of the amplification factor.

The following describes processing (hereinafter, referred to as parameter determination) performed by the range determination function 31 and the representative coefficient determination function 32. The FIR filter is expressed by Expression (1).

$$g(t) = \sum_{n=0}^{N-1} a(n) \cdot f(t-n) \tag{1}$$

The left side of Expression (1) corresponds to an output signal from the FIR filter. $a(n)$ in the right side of Expression (1) corresponds to the n-th filter coefficient, and $f(t-n)$ in the right side corresponds to an input signal input to the FIR filter. $n$ in Expression (1) represents the filter index. As expressed by Expression (1), the total number of filter coefficients in the FIR filter is N. The range of the amplification factor is set by comparing an arithmetic result using the partial filter coefficient sequence with a threshold or comparing the partial filter coefficient sequence with a threshold, which will be described later.

The range determination function 31 performs the following processing as an outline of parameter determination:

1. The range determination function 31 creates a filter index set having only 0 as an element. Based on a filter coefficient $a(0)$ of the filter index 0 and a threshold, the range determination function 31 sets the range of the filter index 0 along the amplification factor axis direction as the range of the amplification factor. The threshold corresponds to a predetermined width along the amplification factor axis direction.
2. The range determination function 31 sets n=1.
3. The range determination function 31 determines whether a filter coefficient $a(n)$ of a filter index n is included in the range of the amplification factor of the previous filter index (n-1) based on the filter coefficient $a(n)$ of the filter index n and the threshold.

4-1. If the filter coefficient a(n) of the filter index n is included in the range of the amplification factor of the filter index (n-1), the range determination function 31 adds the filter index n to the same filter index set as that of the previous filter index.

4-2. If the filter coefficient a(n) of the filter index n is not included in the range of the filter index (n-1), the range determination function 31 determines that it is necessary to treat the filter coefficient a(n) of the filter index n as a filter coefficient having a value different from that of the filter coefficient a(n-1) of the filter index (n-1). In this case, the range determination function 31 generates another filter index set having only the filter index n as an element and generates the range of a first amplification factor for the filter coefficient a(n) of the filter index n.

5. The range determination function 31 increases n by 1. If n is smaller than N, the range determination function 31 performs the processing at 2 again. If n=N is satisfied, the range determination function 31 stores the filter index sets corresponding to all the filter coefficients and ends this processing.

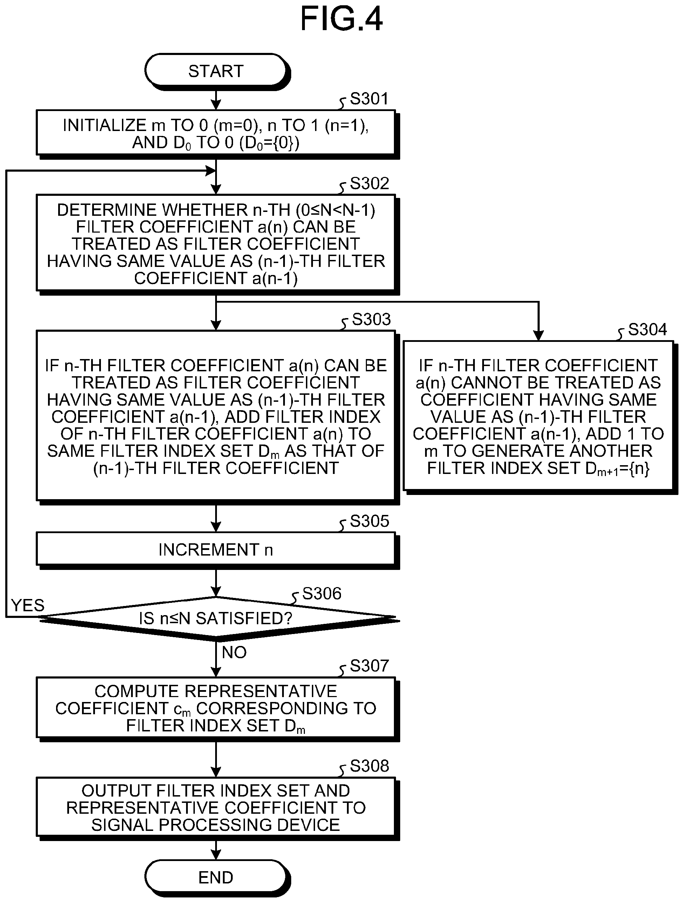

The following describes the process of parameter determination with reference to FIG. 4. FIG. 4 is a flowchart of an example of the process of parameter determination.

Parameter determination

Step S301

The range determination function 31 initializes a set index m to 0 (m=0), a filter index n to 1 (n=1), and elements of the filter index set when m=0 is satisfied to 0 ($D_0=\{0\}$).

Step S302

The range determination function 31 determines whether the n-th ($0 \leq n < N-1$) filter coefficient a(n) can be treated as a filter coefficient having the same value as the (n-1)-th filter coefficient a(n-1).

Step S303

If the n-th filter coefficient a(n) can be treated as a filter coefficient having the same value as the (n-1)-th filter coefficient a(n-1), the range determination function 31 adds the filter index of the n-th filter coefficient a(n) to the same filter index set $D_m$ as that of the (n-1)-th filter coefficient a(n-1).

Step S304

If the n-th filter coefficient a(n) cannot be treated as a coefficient having the same value as the (n-1)-th filter coefficient a(n-1), the range determination function 31 adds 1 to the set index m to generate another filter index set $D_{m+1}=\{n\}$.

Step S305

The range determination function 31 increments n. In other words, the range determination function 31 adds 1 to n to generate a second n.

Step S306

If n is equal to or smaller than N, the range determination function 31 performs the processing at Step S302 and subsequent steps again. If the second n exceeds N, the range determination function 31 performs processing at Step S307. As a result, the partial filter coefficient sequences are extracted from the total filter coefficient sequence.

The range determination function 31 may perform the determination at Step S302 as follows: if $a(n_0^{(m)})-\text{Threshold} \leq a(n) \leq a(n_0^{(m)})+\text{Threshold}$ is satisfied where $n_0^{(m)}$ is the filter index added to the filter index set $D_m$ first, and n is the filter index to be determined at Step S302, for example, the range determination function 31 may determine that the n-th filter coefficient a(n) can be treated as a filter coefficient having the same value.

The range determination function 31 may perform the determination at Step S302 by another method of computing in advance the sum of filter coefficients belonging to the m-th filter index set $D_m$ for the n-1-th filter coefficient, for example. $|D_m|$ denotes the total number of elements in the filter index set $D_m$ (hereinafter, referred to as a duration length). Subsequently, the range determination function 31 may determine the absolute value of the difference between the product of the n-th filter coefficient a(n) and the duration length $|D_m|$ ($|D_m| \times a(n)$) and the computed sum exceeds a threshold. The range determination function 31 determines whether the absolute value of the difference exceeds the threshold and performs one of the processing at Step S303 (when the absolute value does not exceed the threshold) and the processing at Step S304 (when the absolute value exceeds the threshold).

The range determination function 31 may perform the determination at Step S302 by still another method of adding the n-th filter coefficient a(n) to the sum of filter coefficients belonging to the filter index set $D_m$ for the n-1-th filter coefficient and computing the average value of the filter coefficients, for example. The range determination function 31 determines the maximum value and the minimum value of the filter coefficients in the filter coefficients belonging to the filter index set $D_m$ and the n-th filter coefficient a(n). The range determination function 31 determines whether the product of the value obtained by subtracting the average value from the maximum value multiplied by ($|D_m|$+1) exceeds a threshold and performs one of the processing at Step S303 (when the product does not exceed the threshold) and the processing at Step S304 (when the product exceeds the threshold).

Step S307

The representative coefficient determination function 32 computes a representative coefficient $c_m$ corresponding to the filter index set $D_m$. Specifically, the representative coefficient determination function 32 computes the representative coefficient representing a plurality of filter coefficients in the range of the amplification factor corresponding to the filter index set $D_m$ based on the filter coefficients included in the filter index set $D_m$. The representative coefficient is an approximate value of the filter coefficients included in the range of the amplification factor. The representative coefficient determination function 32, for example, computes the average value of the filter coefficients included in the range of the amplification factor as the representative coefficient. The representative coefficient determination function 32, for example, computes the representative coefficient $c_m$ based on Expression (2):

$$c_m = (1 / |D_m|) \sum_{n \in D_m} a(n) \tag{2}$$

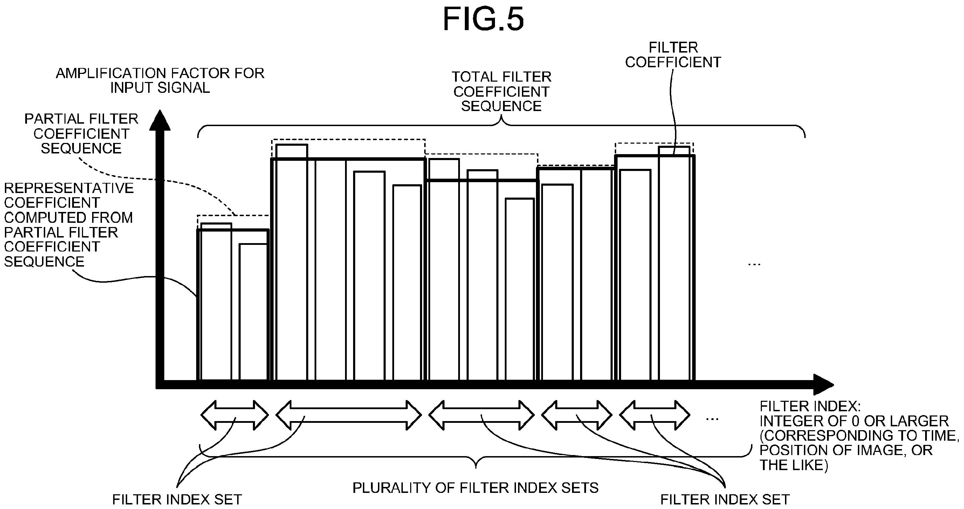

FIG. 5 is a diagram of an example of the representative coefficients computed from the partial filter coefficient sequences for the respective filter index sets. As illustrated in FIG. 5 and expressed by Expression (2), the representative coefficient is computed as the average of the filter coefficients in the partial filter coefficient sequence.

Step S308

The processing circuitry 30 outputs the representative coefficient and the filter index set relating to the range of the amplification factor to the signal processing apparatus 1. The memory 13 of the signal processing apparatus 1 stores therein the representative coefficient and the filter index set in a manner associated with the range of the amplification factor. Filter parameters determined by the range determination function 31 and the representative coefficient determination function 32 correspond to the representative coefficient and the filter index set relating to the range of the amplification factor. If the filter coefficient is a complex number, the representative coefficient is also a complex number. The FIR filter can be performed if the complex number is an object to be processed.

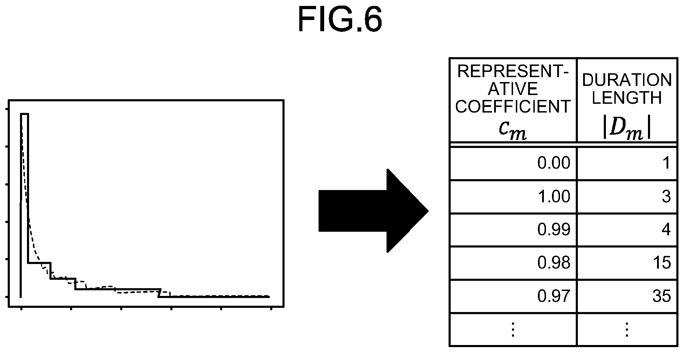

FIG. 6 is a diagram of an example of a graph indicating an output signal (dotted line) in actual measurement and an output signal (dotted line) based on the representative coefficient and an example of the representative coefficient $c_m$ and the duration length $|D_m|$. As illustrated in FIG. 6, the output signal represented by the dotted line is approximated by the representative coefficient $c_m$, which is a piecewise constant. An output signal g(t) is expressed by Expression (3):

$$g(t) = \sum_{m} \left( c_m \sum_{n \in D_m} f(t - n) \right) \tag{3}$$

After the processing at Step S308, determination of the film parameters is completed. Setting the range of the amplification factor and computing the representative coefficient in the parameter determination corresponds to approximate run-length encoding allowing an error by a threshold for the filter index set, for example.

The following describes the components and the processing contents of the signal processing apparatus 1. The signal processing apparatus 1 includes the communication interface 11, the memory 13, and the processing circuitry 15.

The communication interface 11 acquires the filter parameters determined by the filter parameter determining apparatus 3 from the filter parameter determining apparatus 3 via the network. The communication interface 11 acquires an input signal f(t) from the signal input apparatus 7 via the network. The acquired filter parameters and the input signal f(t) are stored in the memory 13. The communication interface 11 outputs output results of the FIR filter computed by the processing circuitry 15 that has received the input signal f(t) to the result output apparatus 5 via the network.

The memory 13 is provided as storage circuitry that stores therein various kinds of information. The embodied aspect of the memory 13 is not explained herein because it is the same as the memory described in the explanation of the filter parameter determining apparatus 3. The memory 13 stores therein various kinds of data received via the communication interface 11. The received various kinds of data include the filter parameters and the input signal f(t), for example. The memory 13 may store therein an output result g(t) output from the processing circuitry 15. The output result is the output signal g(t) obtained by performing the FIR filter on the input signal f(t) and outputting it from the FIR filter.

The processing circuitry 15 is provided as a processor and includes an integral value computation function 151 and a signal value computation function 153, for example. The processing circuitry 15 that implements the integral value computation function 151 and the signal value computation function 153 corresponds to an integral value computing unit and a signal value computing unit. Various functions, such as the integral value computation function 151 and the signal value computation function 153, are stored in the memory 13 as computer-executable programs. The processing circuitry 15, for example, reads out a computer program from the memory 13 and executes it, thereby implementing the function corresponding to the computer program. In other words, the processing circuitry 15 that has read out the computer programs has various functions, such as the integral value computation function 151 and the signal value computation function 153. The embodied aspect of the processor is not explained herein because it is the same as the processor described in the explanation of the filter parameter determining apparatus 3.

The integral value computation function 151 of the processing circuitry 15 adds a value not overlapping a first input sequence in a second input sequence to a first integral value and subtracts a value not overlapping the second input sequence in the first input sequence from the first integral value for each of a plurality of elements in a coefficient sequence, thereby computing a second integral value. The integral value computation function 151 adds up a first input signal throughout the filter indices in the filter index set for each of the ranges of the amplification factor for the first input signal input to the finite impulse response digital filter, thereby computing the first integral value. The signal value computation function 153 of the processing circuitry 15 adds up the product of the representative coefficient and the first integral value computed for each of the ranges of the amplification factor throughout the set indices, thereby computing a first output signal value to be output from the FIR filter.

After receiving a second input signal next to the first input signal, the integral value computation function 151 adds the second input signal shifted by the maximum filter index to the first integral value and subtracts the first input signal shifted by the minimum filter index from the first integral value for each of the ranges of the amplification factor, thereby computing the second integral value. The signal value computation function 153 adds up the product of the representative coefficient and the second integral value throughout the set indices, thereby computing a second output signal value to be output from the FIR filter.

After receiving a third input signal next to the second input signal, the integral value computation function 151 adds the third input signal shifted by the maximum filter index to the second integral value and subtracts the second input signal shifted by the minimum filter index from the second integral value for each of the ranges of the amplification factor, thereby computing a third integral value. The signal value computation function 153 adds up the product of the representative coefficient and the third integral value throughout the set indices, thereby computing a third output signal value to be output from the FIR filter.

The specific contents of the processing performed by the integral value computation function 151 and the signal value computation function 153 will be described later in explanation of processing of performing the FIR filter on input signals using the filter parameters (hereinafter, referred to as filter arithmetic processing).

The number of bits in the filter coefficients, the representative coefficients, the first integral values, and the second integral values according to the present embodiment is larger than the number of bits of the input signal f(t). The number of bits in the filter coefficients, the representative coefficients, the first integral values, and the second integral values is larger than 32, for example.

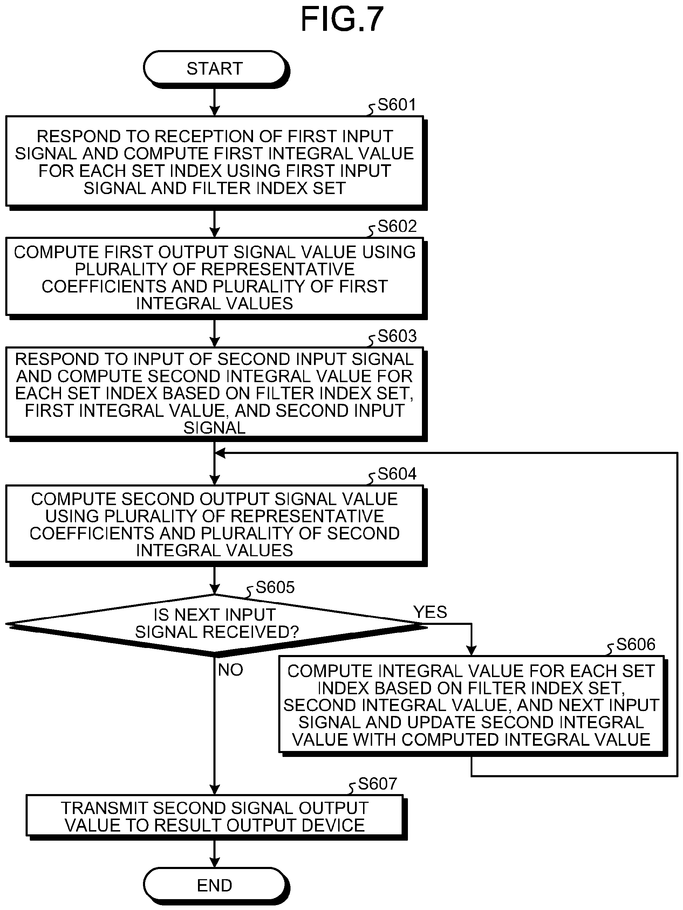

The following describes filter arithmetic processing performed by the signal processing apparatus 1 according to the present embodiment having the configuration described above with reference to FIGS. 7 to 9. FIG. 7 is a flowchart of an example of the process of filter arithmetic processing.

Filter arithmetic processing

Step S601

The integral value computation function 151 responds to reception of a first input signal f(t) and computes a first integral value for each of the ranges of the amplification factor, that is, for each set index using the first input signal f(t). Specifically, the integral value computation function 151 computes a first integral value $I_m(t)$ for each set index m using the filter index n serving as an element of the filter index set $D_m$ and the first input signal f(t) based on Expression (4). As expressed by Expression (1) to Expression (4), the filter index n distinguishes a plurality of filter coefficients belonging to the ranges of the amplification factor. The filter index n, for example, distinguishes the filter coefficients based on delay in the first input signal f(t).

$$I_m(t) = \sum_{n \in D_m} f(t - n) \qquad (4)$$

The integral value computation function 151 stores the computed first integral value $I_m(t)$ in the memory 13. In other words, the memory 13 stores therein a plurality of first integral values corresponding to the set index m.

Step S602

The signal value computation function 153 computes a first output signal value using a plurality of representative coefficients $c_m$ and a plurality of first integral values $I_m(t)$. Specifically, the signal value computation function 153 adds up the first integral value $I_m(t)$ throughout the set indices m, thereby computing a first output signal value g(t) as expressed by Expression (5):

$$g(t) = \sum_m \left( c_m \cdot I_m(t) \right) \qquad (5)$$

The signal value computation function 153 stores the computed first output signal value in the memory 13.

Step S603

The integral value computation function 151 responds to input of the next input signal (hereinafter, referred to as a second input signal) and computes a second integral value $I_m(t+1)$ for each set index m based on the filter index set $D_m$, the first integral value $I_m(t)$, the first input signal, and the second input signal. Input of the second input signal corresponds to incrementing the argument t of the input signal f(t) (t→t+1).

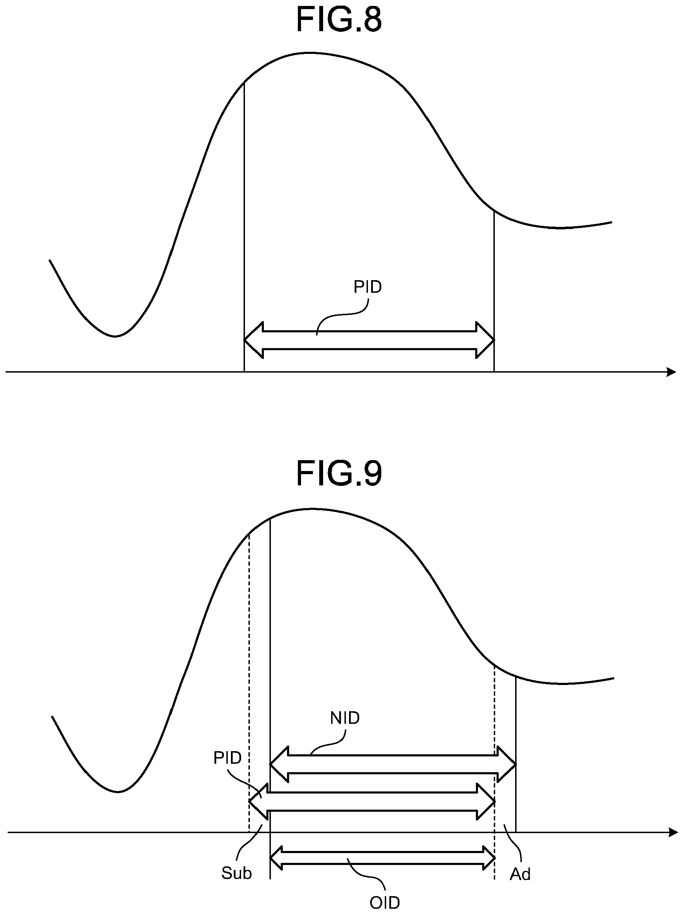

FIG. 8 is a diagram of an example of an interval in which the first integral value is computed (hereinafter, referred to as a prior integration interval) PID. The horizontal axis in FIG. 8 is the pseudo time-axis direction, for example. At this step, an integral value in an integration interval by the second input signal (hereinafter, referred to as a next integration interval) is computed using the first integral value in the prior integration interval PID.
FIG. 9 is a diagram of an example of the prior integration interval PID, a next integration interval NID, and an outline of computation performed on the next integration interval NID. The integral value computation function 151 computes the second integral value $I_m(t+1)$ in the next integration interval NID for each set index m using the first integral value corresponding to the prior integration interval PID.
Specifically, the integral value computation function 151 adds a second input signal f(t+1-max $D_m$) shifted by the maximum filter index (max $D_m$) to the first integral value $I_m(t)$ and subtracts a first input signal f(t-min $D_m$) shifted by the minimum filter index (min $D_m$) from the first integral value $I_m(t)$ for each of the ranges of the amplification factor, that is, for each set index m, thereby computing the second integral value $I_m(t+1)$. In other words, the integral value computation function 151 computes the second integral value $I_m(t+1)$ based on Expression (6).

$$I_m(t + 1) = I_m(t) + f(t + 1 - \max D_m) - f(t - \min D_m) \qquad (6)$$

The first term $I_m(t)$ of the right side in Expression (6) represents the first integral value. The second term f(t+1-

max $D_m$) of the right side in Expression (6) represents the second input signal in an interval Ad in FIG. 9. The third term f(t-min $D_m$) of the right side in Expression (6) represents the first input signal in an interval Sub in FIG. 9. In other words, as illustrated in FIG. 9 and expressed by Expression (6), the second integral value $I_m(t+1)$ in the next integration interval NID is computed by subtracting the first input signal corresponding to the interval Sub from the first integral value $I_m(t)$ corresponding to the prior integration interval PID and adding the second input signal corresponding to the interval Ad to the first integral value $I_m(t)$. As a result, the integral value computation function 151 computes the second integral value $I_m(t+1)$ in the next integration interval NID.

The second integral value $I_m(t+1)$ is computed at this step using a one-dimensional variant of a sliding window algorithm similar to the Viola-Jones algorithm, for example. At this time, the first integral value $I_m(t)$ has already been computed as expressed by Expression (6). As a result, the number of times of computation of the second integral value $I_m(t+1)$ in the next integration interval NID is significantly reduced. The order of computational complexity is reduced from N corresponding to Expression (1) to the duration length $|D_m|$ corresponding to Expression (3), for example.

Step S604

The signal value computation function 153 computes a second output signal value using a plurality of representative coefficients $c_m$ and a plurality of second integral values $I_m(t+1)$. Specifically, the signal value computation function 153 adds up the product of the second integral value $I_m(t+1)$ and the representative coefficient $c_m$ throughout the set indices m, thereby computing a second output signal value g(t+1) as expressed by Expression (7):

$$g(t + 1) = \sum_m \left( c_m \cdot I_m(t + 1) \right) \qquad (7)$$

The signal value computation function 153 stores the computed second output signal value in the memory 13.

Step S605

If the next input signal is received, the processing at Step S606 is performed. Receiving the next input signal corresponds to incrementing the argument of the output signal. If the next input signal is not received, the processing at Step S607 is performed.

Step S606

The integral value computation function 151 computes a third integral value for each set index m of the filter index set based on the filter index set $D_m$, the second integral value $I_m(t+1)$, and the third input signal next to the second input signal. The integral value computation function 151 updates the second integral value with the third integral value computed at this step and stores it in the memory 13. Computation of the third integral value at this step is not explained herein because it is the same as the computation at Step S603. After this step, the processing at Step S604 is performed.

Step S607

The signal processing apparatus 1 transmits the second signal output value output from the FIR filter to the result output apparatus 5 via the communication interface 11. After this step, the filter arithmetic processing is completed.
The signal processing apparatus 1 according to the embodiment described above adds up the first input signal throughout the filter indices for each of the ranges of the amplification factor, thereby computing the first integral value. The signal processing apparatus 1 adds up the product of the representative coefficient and the first integral value computed for each of the ranges of the amplification factor throughout the set indices, thereby computing the first output signal value. After receiving the second input signal next to the first input signal, the signal processing apparatus 1 adds the second input signal shifted by the maximum filter index to the first integral value and subtracts the first input signal shifted by the minimum filter index from the first integral value for each of the ranges of the amplification factor, thereby computing the second integral value. The signal processing apparatus 1 adds up the product of the representative coefficient and the second integral value throughout the set indices, thereby computing the second output signal value to be output from the digital filter.
The signal processing apparatus 1 according to the embodiment computes a plurality of first integral values (e.g., $I_m(t)$) corresponding to a plurality of elements (e.g., a plurality of representative coefficients $c_m$) in a coefficient sequence (e.g., a set of $c_m$ corresponding to the sequence of the representative coefficients $c_m$) based on a first input sequence (e.g., f(t)). The signal processing apparatus 1 computes a plurality of second integral values (e.g., $I_m(t+1)$) corresponding to the elements based on a second input sequence (e.g., f(t+1)) next to the first input sequence. The signal processing apparatus 1 includes an integral value computing unit and a signal value computing unit. The integral value computing unit adds a value (e.g., f(t+1-max $D_m$)) not overlapping the first input sequence in the second input sequence to the first integral value and subtracts a value (e.g., f(t-min $D_m$)) not overlapping the second input sequence in the first input sequence from the first integral value for each of the elements, thereby computing the second integral value. The signal value computing unit computes an output signal value (e.g., g(t+1)) corresponding to the second input sequence based on the second integral value and the coefficient sequence. The coefficient sequence corresponds to a sequence of a series of amplification factors corresponding to the input sequence. The elements are each a representative coefficient representing a plurality of filter coefficients included in the range defined by the values of the filter coefficients. The coefficient sequence is a series of representative coefficients.

After receiving the third input signal next to the second input signal, the signal processing apparatus 1 according to the embodiment adds the third input signal shifted by the maximum filter index to the second integral value and subtracts the second input signal shifted by the minimum filter index from the second integral value for each of the ranges of the amplification factor, thereby computing the third integral value. The signal processing apparatus 1 adds up the product of the representative coefficient and the third integral value throughout the set indices, thereby computing the third output signal value to be output from the digital filter. Shifting the input signal corresponds to delay in the input signal, for example.

The signal processing apparatus 1 according to the embodiment computes a plurality of third integral values (e.g., $I_m(t+2)$) corresponding to a plurality of elements for a third input sequence (e.g., f(t+2)) next to the second input sequence. The integral value computing unit adds a value (e.g., f(t+2-max $D_m$)) not overlapping the second input sequence in the third input sequence to the second integral value and subtracts a value (e.g., f(t+1-min $D_m$)) not overlapping the third input sequence in the second input sequence from the second integral value for each of the elements, thereby computing the third integral value. The signal value computing unit computes an output signal value (e.g., g(t+2)) corresponding to the third input sequence based on the third integral value and the coefficient sequence. Non-overlapping corresponds to delay in the input sequence, for example.

In the signal processing apparatus 1 according to the embodiment, the representative coefficient corresponds to the average of a plurality of filter coefficients included in a plurality of ranges of the amplification factor. The ranges of the amplification factor are each set by comparing an arithmetic result using a plurality of filter coefficients with a threshold or comparing the filter coefficients with a threshold.

As described above, the signal processing apparatus 1 performs computation of the FIR filter based on the properties of the filter coefficients in the FIR filter that the values of filter coefficients having close filter indices are often close. The signal processing apparatus 1 performs the computation using the representative coefficient of the filter coefficients computed for each of the ranges of the amplification factor defined by the threshold and the second integral value computed using the one-dimensional sliding window algorithm for each of the ranges of the amplification factor. The signal processing apparatus 1 performs the computation, thereby reducing computational complexity for computing the second-or-higher integral values in the FIR filter, that is, achieving acceptable computational complexity. Consequently, the signal processing apparatus 1 can output the arithmetic result of the FIR filter in an acceptable computational time.

In the signal processing apparatus 1 according to the embodiment, the number of bits in the filter coefficients, the representative coefficients, the first integral values, and the second integral values is larger than the number of bits of the input signal. Specifically, the number of bits in the filter coefficients, the representative coefficients, the first integral values, and the second integral values is larger than 32, for example. As a result, the signal processing apparatus 1 can prevent cancellation of significant digits in the first integral value and the second integral value independently of the data amount of the input signal in the process of computing the first integral value and the second integral value in filter arithmetic processing. Consequently, the signal processing apparatus 1 can prevent fatal damage on the computation result of the FIR filter.

The filter parameter determining apparatus 3 according to the embodiment stores therein the partial filter coefficient sequences for the respective set indices. Based on the partial filter coefficient sequence corresponding to the filter index set being processed, the filter parameter determining apparatus 3 determines the range of the amplification factor of the filter coefficients determined to be included in the filter index set. The filter parameter determining apparatus 3 determines the representative coefficient representing the filter coefficients for each of the ranges of the amplification factor. As a result, the signal processing apparatus 1 can perform an arithmetic operation of the FIR filter using the representative coefficient. Consequently, the signal processing apparatus 1 can output the arithmetic result of the FIR filter in an acceptable computational time.

Consequently, the signal processing apparatus 1 can increase the computational speed of the FIR filter and put an FIR filter with a large number of taps to practical use.

Second embodiment

The present embodiment is an application example of filter arithmetic processing relating to a magnetic resonance imaging apparatus including the signal processing apparatus 1. The signal processing apparatus 1 mounted on the magnetic resonance imaging apparatus uses a signal value (hereinafter, referred to as a control signal value) for controlling an electric current to be supplied to a gradient coil in a pulse sequence as the input signal described above and outputs a position in a k-space (hereinafter, referred to as a k-space position) as the second output signal value. The magnetic resonance imaging apparatus corrects the k-space position of magnetic resonance data (hereinafter, referred to as MR data) generated by performing the pulse sequence or modifies the pulse sequence based on the k-space position. Outputting the second output signal value according to the present embodiment is effective especially for a smooth waveform in impulse response relating to a gradient coil.

Due to an influence of an eddy current, for example, an electric current waveform for generating the gradient magnetic field may be deformed from an expected waveform based on the pulse sequence. Because of this, the k-space position output from the signal processing apparatus 1 as the second output signal value may represent an offset position with respect to an expected position in the k-space based on the pulse sequence (hereinafter, referred to as an ideal position).

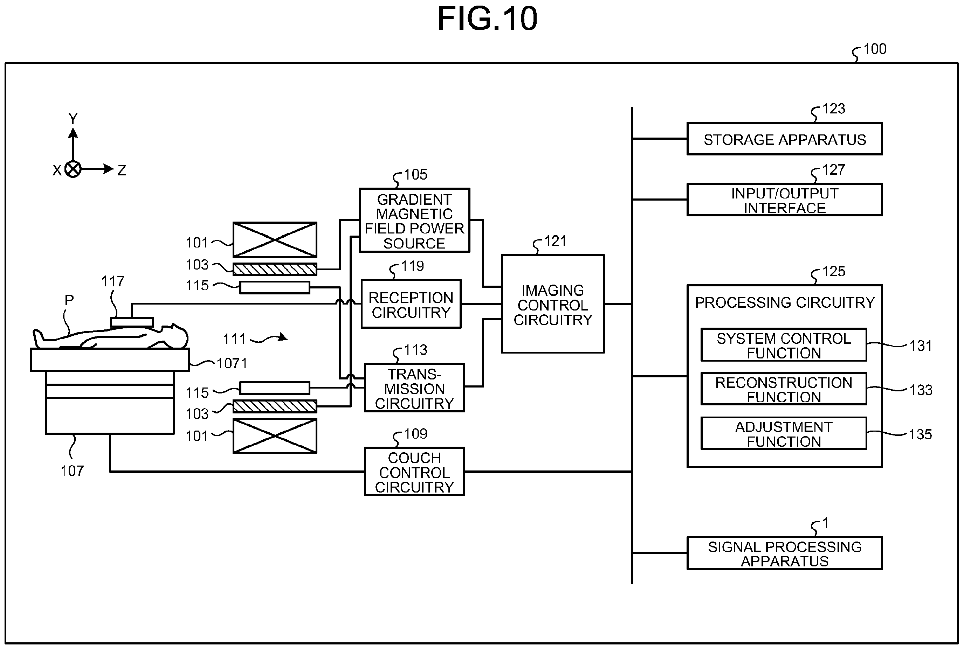

FIG. 10 is a block diagram of an example of a magnetic resonance imaging apparatus 100 according to the present embodiment. As illustrated in FIG. 10, the magnetic resonance imaging apparatus 100 includes the signal processing apparatus 1. In a modification of the present embodiment, the integral value computation function 151 and the signal value computation function 153 may be mounted on processing circuitry 125.

As illustrated in FIG. 10, the magnetic resonance imaging apparatus 100 includes a static magnetic field magnet 101, a gradient coil 103, a gradient magnetic field power source 105, a couch 107, couch control circuitry 109, transmission circuitry 113, a transmission coil 115, a reception coil 117, reception circuitry 119, imaging control circuitry 121, a storage apparatus 123, processing circuitry 125, an input/output interface 127, and the signal processing apparatus 1.

The static magnetic field magnet 101 is a hollow magnet having a substantially tubular shape. The static magnetic field magnet 101 generates a substantially uniform static magnetic field in the internal space. The static magnetic field magnet 101 is a superconducting magnet, for example.

The gradient coil 103 is a hollow coil having a substantially tubular shape and is disposed on the inner surface of a tubular cooling container. The gradient coil 103 independently receives an electric current from the gradient magnetic field power source 105 and generates a gradient magnetic field having magnetic field intensity that changes along X-, Y-, and Z-axes orthogonal to one another. The gradient magnetic field in the X-, Y-, and Z-axes generated by the gradient coil 103 forms a slice selection gradient magnetic field, a phase encoding gradient magnetic field, and a frequency encoding gradient magnetic field (hereinafter, referred to as a read-out gradient magnetic field), for example. The slice selection gradient magnetic field is used to optionally determine an imaging section. The phase encoding gradient magnetic field is used to change the phase of magnetic resonance signals depending on the spatial position. The frequency encoding gradient magnetic field is used to change the frequency of magnetic resonance signals depending on the spatial position.

The gradient magnetic field power source 105 is a power supply apparatus that supplies an electric current to the gradient coil 103 under the control of the imaging control circuitry 121.

The couch 107 is an apparatus including a couchtop 1071 on which a subject P is placed. The couch 107 inserts the couchtop 1071 with the subject P placed thereon into a bore 111 under the control of the couch control circuitry 109.

The couch control circuitry 109 controls the couch 107. The couch control circuitry 109 drives the couch 107 based on an instruction given by an operator through an input/output interface 17, thereby moving the couchtop 1071 in the longitudinal and vertical directions and the horizontal direction in some cases.

The transmission circuitry 113 supplies high frequency pulses modulated at the Larmor frequency to the transmission coil 115 under the control of the imaging control circuitry 121. The transmission circuitry 113 includes an oscillating unit, a phase selecting unit, a frequency converting unit, an amplitude modulating unit, and an RF amplifier, for example. The oscillating unit generates RF pulses at a resonance frequency unique to a target atomic nucleus in the static magnetic field. The phase selecting unit selects the phase of the RF pulses generated by the oscillating unit. The frequency converting unit converts the frequency of the RF pulses output from the phase selecting unit. The amplitude modulating unit modulates the amplitude of the RF pulses output from the frequency converting unit based on the sinc function, for example. The RF amplifier amplifies the RF pulses output from the amplitude modulating unit and supplies them to the transmission coil 115.

The transmission coil 115 is a radio frequency (RF) coil disposed on the inner side of the gradient coil 103. The transmission coil 115 generates RF pulses corresponding to a high frequency magnetic field due to output from the transmission circuitry 113.

The reception coil 117 is an RF coil disposed on the inner side of the gradient coil 103. The reception coil 117 receives magnetic resonance signals output from the subject P by the high frequency magnetic field. The reception coil 117 outputs the received magnetic resonance signals to the reception circuitry 119. The transmission coil 115 and the reception coil 117 may be provided as an integrated transmission/reception coil.

The reception circuitry 119 generates MR data corresponding to digital MR signals (hereinafter, referred to as MR data) based on the magnetic resonance signals output from the reception coil 117 under the control of the imaging control circuitry 121. Specifically, the reception circuitry 119 performs various signal processing on the MR signals output from the reception coil 117. Subsequently, the reception circuitry 119 performs analog to digital (A/D) conversion (hereinafter, referred to as A/D conversion) on the data resulting from the various signal processing to generate MR data. The reception circuitry 119 outputs the generated MR data to the imaging control circuitry 121.

The imaging control circuitry 121 controls the gradient magnetic field power source 105, the transmission circuitry 113, the reception circuitry 119, and other components according to an imaging protocol output from the processing circuitry 125 and performs imaging on the subject P. The imaging protocol has a pulse sequence corresponding to the type of an examination. The imaging protocol defines imaging parameters such as the magnitude of an electric current supplied to the gradient coil 103 by the gradient magnetic field power source 105, the timing at which the gradient magnetic field power source 105 supplies the electric current to the gradient coil 103, the magnitude and the time width of high frequency pulses supplied to the transmission coil 115 by the transmission circuitry 113, the timing at which the transmission coil 115 supplies the high frequency pulses to the transmission coil 115, and the timing at which the reception coil 117 receives MR signals, for example. When the imaging control circuitry 121 images the subject P by driving the gradient magnetic field power source 105, the transmission circuitry 113, the reception circuitry 119, and other components and receives MR data from the reception circuitry 119, it transfers the received MR data to the processing circuitry 125 or the like. The imaging control circuitry 121 is provided as a processor, for example.

The storage apparatus 123 stores therein various computer programs executed by the processing circuitry 125, various imaging protocols, and imaging conditions including a plurality of imaging parameters defining the imaging protocols, for example. The embodied aspect of the storage apparatus 123 is not explained herein because it is the same as the memory 13. Data stored in the storage apparatus 123 may be stored in the memory 13. In this case, the memory 13 functions as an alternative to the storage apparatus 123.

The processing circuitry 125 includes a system control function 131, a reconstruction function 133, and an adjustment function 135. Various functions implemented by the system control function 131, the reconstruction function 133, and the adjustment function 135 are stored in the storage apparatus 123 as computer-executable programs. The processing circuitry 125 is a processor that reads out the computer programs corresponding to the various functions from the storage apparatus 123 and executes the read-out programs, thereby implementing the functions corresponding to the respective computer programs. In other words, the processing circuitry 125 that has read out the computer programs has a plurality of functions or the like illustrated in the processing circuitry 125 in FIG. 10. The processing circuitry 125 that implements the system control function 131, the reconstruction function 133, and the adjustment function 135 corresponds to a system controlling unit, a reconstructing unit, and an adjusting unit. Hardware resources that fabricate the processing circuitry 125 are not explained herein because they are the same as those of the processing circuitry 125 mounted on the signal processing apparatus 1.

The system control function 131 reads out a system control program stored in the storage apparatus 123 and loads it on a memory. The system control function 131 controls the circuitry of the magnetic resonance imaging apparatus 100 according to the loaded system control program. The system control function 131, for example, reads out an imaging protocol from the storage apparatus 123 based on imaging conditions input by the operator through the input/output interface 127. The system control function 131 may generate the imaging protocol based on the imaging conditions. The system control function 131 transmits the imaging protocol to the imaging control circuitry 121 and controls imaging on the subject P.

The reconstruction function 133 fills the k-space with MR data along a read-out direction in the k-space based on the strength of the read-out gradient magnetic field. The reconstruction function 133 performs inverse Fourier transform on the MR data with which the k-space is filled, thereby generating an MR image. The reconstruction function 133 outputs the MR image to the storage apparatus 123 and the input/output interface 127.

The adjustment function 135 corrects the position in the k-space of the MR data generated by performing the pulse sequence based on the k-space position output from the signal processing apparatus 1. The k-space position output from the signal processing apparatus 1 corresponds to the strength of the read-out gradient magnetic field. Specifically, the adjustment function 135 corrects the position of the MR data with which the k-space is filled along the read-out direction in the k-space based on the k-space position. The reconstruction function 133 performs inverse Fourier transform on the MR data with which the k-space is filled using the corrected position in the k-space, thereby generating an MR image.

Herein, correcting the position in the k-space refers to, for example, correcting, to an ideal position, the position in the k-space of the MR data generated by performing the pulse sequence based on the k-space position output from the signal processing apparatus 1. More specifically, correcting the position in the k-space refers to obtaining, as an amount of shift, an offset between the ideal position and the k-space position output from the signal processing apparatus 1 to shift the position in the k-space of the MR data generated by performing the pulse sequence to the ideal position.

The adjustment function 135 modifies the pulse sequence relating to main scanning based on the k-space position output from the signal processing apparatus 1. Specifically, the adjustment function 135 modifies an electric current waveform for generating the gradient magnetic field, such as the magnitude of an electric current to be supplied to the gradient coil 103 and the timing at which the gradient magnetic field power source 105 supplies the electric current to the gradient coil 103, and the timing at which the reception coil 117 receives MR signals, for example, in the pulse sequence based on the k-space position. The timing is a timing at which an A/D converter in the reception circuitry 119 is turned ON, for example. The imaging control circuitry 121 performs scanning on the subject P using the modified pulse sequence.

Modifying the pulse sequence relating to main scanning refers to, for example, obtaining, as an amount of shift, an offset between the ideal position and the k-space position output from the signal processing apparatus 1, and correcting either or both of the strength of the gradient magnetic field and a length of time for which the gradient magnetic field is applied so that the position in the k-space of the MR data generated by performing the pulse sequence is shifted to the ideal position. More specifically, modifying the pulse sequence refers to correcting either or both of a signal value to be supplied to the gradient coil 103 and a length of time for which the signal value is applied. The signal value corresponds to a voltage to be supplied to the gradient coil 103.

Outputting the k-space position by the signal processing apparatus 1 and processing performed by the adjustment function 135 will be described later in greater detail. The processing corresponds to performing the FIR filter using the filter parameter and the control signal value and performing the correction or the modification described above using the k-space position corresponding to the output result from the FIR filter (hereinafter, referred to as adjustment).

The input/output interface 127 includes an input interface and an output interface. The input interface includes circuitry relating to a pointing device, such as a mouse, or an input device, such as a keyboard, and an input terminal from the network, for example. The circuitry included in the input interface is not limited to circuitry relating to physical operating parts, such as a mouse and a keyboard. The input interface, for example, may include processing circuitry that receives electrical signals corresponding to an input operation from an external input device provided separately from the magnetic resonance imaging apparatus 100 and outputs the received electrical signals to various kinds of circuitry.

The output interface includes a display and an output terminal to the network, for example. The display displays various MR images reconstructed by the reconstruction function 133 and various kinds of information on imaging and image processing under the control of the processing circuitry 131. The display is a display device, such as a CRT display, a liquid crystal display, an organic EL display, an LED display, a plasma display, or other desired displays or monitors known in the present technical field.

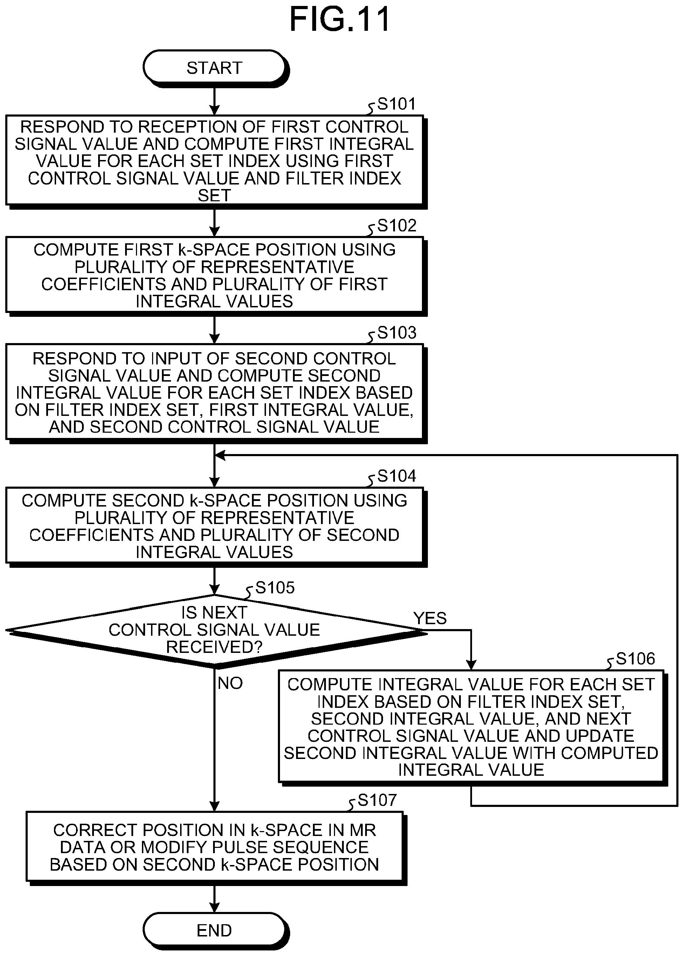

The following describes adjustment performed by the magnetic resonance imaging apparatus 100 according to the present embodiment having the configuration described above with reference to FIG. 11. FIG. 11 is a flowchart of an example of the process of adjustment. The processing contents from Step S101 to Step S106 in the flowchart in FIG. 11 corresponds to the processing contents from Step S601 to Step S606 in the flowchart in FIG. 7 approximately changed so as to match the magnetic resonance imaging apparatus 100. For this reason, the following describes part of the processing contents in the flowchart in FIG. 11 different from those in the flowchart in FIG. 7.

Adjustment processing

Step S101

The integral value computation function 151 responds to reception of a first control signal value serving as the first input signal f(t) and computes a first integral value for each of the ranges of the amplification factor, that is, for each set index using the first control signal value. Specifically, the integral value computation function 151 computes the first integral value $I_m(t)$ for each set index m using the elements of the filter index set $D_m$ and the first control signal value f(t) based on Expression (4). The integral value computation function 151 stores the computed first integral value $I_m(t)$ in the memory 13 in a manner associated with the set index m.

Step S102

The signal value computation function 153 computes a first output signal value as a first k-space position using a plurality of representative coefficients $c_m$ and a plurality of first integral values $I_m(t)$. Specifically, the signal value computation function 153 adds the first integral value $I_m(t)$ throughout the set indices m, thereby computing a first k-space position g(t) using Expression (5). The signal value computation function 153 stores the computed first k-space position in the memory 13.

Step S103

The integral value computation function 151 responds to input of the next input signal (hereinafter, referred to as a second control signal value) and computes a second integral value $I_m(t+1)$ for each set index m based on the filter index set $D_m$, the first integral value $I_m(t)$, the first control signal value, and the second control signal value. Specifically, the integral value computation function 151 adds a second control signal value $f(t+1-\max D_m)$ to the first integral value $I_m(t)$ and subtracts a first input signal $f(t-\min D_m)$ from the first integral value $I_m(t)$, thereby computing the second integral value $I_m(t+1)$ as expressed by Expression (6).

Step S104

The signal value computation function 153 computes a second output signal value as a second k-space position using a plurality of representative coefficients $c_m$ and a plurality of second integral values $I_m(t+1)$. Specifically, the signal value computation function 153 adds up the second integral value $I_m(t+1)$ throughout the set indices m, thereby computing a second k-space position $g(t+1)$ as expressed by Expression (7). The signal value computation function 153 stores the computed second k-space position in the memory 13.

Step S105

If the next control signal value is received, the processing at Step S106 is performed. If the next control signal value is not received, the processing at Step S107 is performed. The second k-space position is output to the processing circuitry 125 of the magnetic resonance imaging apparatus 100.

Step S106

The integral value computation function 151 computes an integral value for each set index m based on the filter index set $D_m$, the second integral value $I_m(t+1)$, and the control signal value next to the second control signal value. The integral value computation function 151 updates the second integral value with the integral value computed at this step and stores it in the memory 13. Computation of the integral value at this step is not explained herein because it is the same as the computation at Step S103. After this step, the processing at Step S104 is performed.

Step S107

The adjustment function 135 corrects the position in the k-space in the MR data or modifies the pulse sequence based on the second k-space position. After the main scanning is performed on the subject P, for example, the adjustment function 135 corrects the k-space position in the MR data based on the second k-space position. At this time, the reconstruction function 133 fills the k-space with the MR data using the corrected k-space position. Subsequently, the reconstruction function 133 performs inverse Fourier transform on the MR data with which the k-space is filled, thereby generating an MR image.
Instead of correcting the k-space position, the adjustment function 135 may modify the pulse sequence based on the second k-space position. Before the main scanning is performed on the subject P, for example, the adjustment function 135 modifies the imaging parameter in the pulse sequence relating to the main scanning based on the second k-space position. Subsequently, the imaging control circuitry 121 performs the main scanning on the subject P using the modified pulse sequence.
In the magnetic resonance imaging apparatus 100 according to the embodiment described above, the signal processing apparatus 1 outputs the position in the k-space as the second output signal value using the signal value for controlling an electric current to be supplied to the gradient coil 103 in the pulse sequence as the input signal. The magnetic resonance imaging apparatus 100 corrects the position in the k-space of magnetic resonance data generated by performing the pulse sequence or modifies the pulse sequence based on the position in the k-space. If exponential delay occurs in the strength of the gradient magnetic field due to an eddy current by performing the pulse sequence for frequently adjusting an electric current to be supplied to the gradient coil 103 (e.g., adjustment of an electric current with which the gradient magnetic field strength has a trapezoidal shape), the magnetic resonance imaging apparatus 100 can output an accurate gradient magnetic field strength as the second output signal value.
In other words, in the magnetic resonance imaging apparatus 100, the signal processing apparatus 1 outputs the position in the k-space as the output signal value using the signal value for controlling an electric current to be supplied to the gradient coil 103 in the pulse sequence as the input sequence. The magnetic resonance imaging apparatus 100 corrects the position in the k-space of the magnetic resonance data generated by performing the pulse sequence or modifies the pulse sequence based on the position in the k-space.

Let us assume a case where a convolution operation of 100,000 taps needs to be performed for a resolution of ten microseconds and an impulse response of one second, and a case where a convolution operation of 3,000,000 taps needs to be performed for a resolution of one microsecond and an impulse response of three seconds, for example. In this case, the magnetic resonance imaging apparatus 100 can perform a convolution operation required for computing the gradient magnetic field strength on a significantly long impulse response associated with an eddy current using the control signal value as an impulse in an acceptable short time. Alternatively, the magnetic resonance imaging apparatus 100 can perform a convolution operation on a significantly long impulse response used by an emphasis filter for cancelling such an eddy current in an acceptable short time, for example.

The signal processing apparatus 1 in the magnetic resonance imaging apparatus 100 can compute the second output signal value with high accuracy and high resolution in a short time without using the Bloch simulator deviating from reality or infinite impulse response (hereinafter, referred to as IIR) by a model assumed by exponential impulse response. The signal processing apparatus 1, for example, can prevent output accuracy from reaching an upper limit due to an error (bias) of the model in IIR because it uses the FIR filter.

With these mechanisms, the magnetic resonance imaging apparatus 100 can fabricate the FIR filter that can accurately compute impulse response (deformation of the waveform of the gradient magnetic field strength) relating to an eddy current in an electric current to be supplied to the gradient coil 103 at high speed and that matches the physical state or the logical design in a simpler manner. The magnetic resonance imaging apparatus 100 modifies the pulse sequence based on the design value in a manner matching an actual physical state in the gradient coil 103 or corrects the k-space position of the MR data in a manner matching an actual k-space position. Consequently, the magnetic resonance imaging apparatus 100 can reduce the gap between the design value and the actual position in the k-space in a trajectory in the k-space and suppress degradation of the image quality of a generated MR image. Other advantageous effects according to the present embodiment are not explained herein because they are the same as those according to the first embodiment.

While the second embodiment describes the magnetic resonance imaging apparatus 100 as an application example of the signal processing apparatus 1 according to the first embodiment, the application example of the signal processing apparatus 1 is not limited to the second embodiment. The signal processing apparatus 1, for example, can compute impulse response of sound by simulating various acoustic (sound reflection) models (e.g., a reflected sound source model or ray tracing).

Application examples

The present application example may input a sequence of constants piecewise as the input sequence or output a sequence of constants piecewise. To make a specific explanation, the following describes the control signal value for controlling an electric current to be supplied to the gradient coil as the input sequence. The control signal value is also referred to as a gradient system transfer function (GSTF).

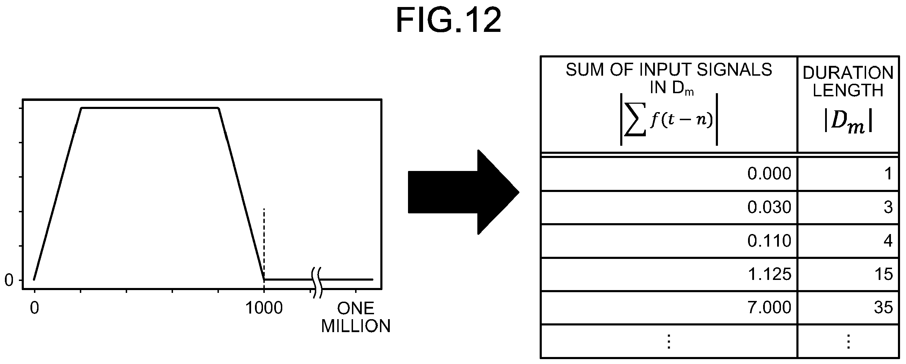

FIG. 12 is a diagram of an example of a graph of the gradient system transfer function (GSTF) and an example of the sum of input signals in $D_m$ and the duration length. If the GSTF has a trapezoidal shape as illustrated in FIG. 12, a sequence of constants is arrayed on the upper base of the trapezoid and after the vertex (1000) at the lower right end of the trapezoid. If a sequence of constants is input piecewise as the input sequence on the upper base of the trapezoid and after the vertex at the lower right end of the trapezoid in the GSTF illustrated in FIG. 12, non-overlapping values added to or subtracted from the first integral value are equal. As a result, the addition and the subtraction at Step S604 and Step S606 are skipped. The second integral value is output piecewise as a sequence of constants. Whether to skip the addition and the subtraction is determined by the integral value computation function 151 monitoring the input sequence in real time, for example. The integral value computation function 151, for example, determines whether to skip the addition and the subtraction based on the duration length $|D_m|$ relating to the input sequence of constants. Specifically, if the duration length $|D_m|$ relating to the input sequence of constants is equal to or longer than a predetermined length, the integral value computation function 151 determines that the addition and the subtraction can be skipped. In this case, the addition and the subtraction at Step S604 and Step S606 are skipped.

If a sequence of constants is input piecewise as the input sequence, the present application example can skip the addition and the subtraction in filter arithmetic processing. In the graph illustrated in FIG. 12, for example, the input sequence has 0s from 1000 to 1,000,000. For this reason, the addition and the subtraction in filter arithmetic processing are skipped. Consequently, the present application example can perform filter arithmetic processing at higher speed. Other advantageous effects according to the present application example are not explained herein because they are the same as those according to the first embodiment.

To implement the technical ideas according to the embodiments by a signal processing method, the signal processing method includes: adding up the first input signal throughout the filter indices for distinguishing a plurality of filter coefficients belonging to a plurality of ranges of the amplification factor for the first input signal input to the FIR filter for each of the ranges of the amplification factor, thereby computing the first integral value; adding up the product of the representative coefficient representing the filter coefficients and the first integral value computed for each of the ranges of the amplification factor throughout the set indices for distinguishing sets of the filter indices, thereby computing the first output signal value to be output from the digital filter; adding, after receiving the second input signal next to the first input signal, the second input signal shifted by the maximum filter index to the first integral value and subtracting the first input signal shifted by the minimum filter index from the first integral value for each of the ranges of the amplification factor, thereby computing the second integral value; and adding up the product of the representative coefficient and the second integral value throughout the set indices, thereby computing the second output signal value to be output from the digital filter. The process and the advantageous effects of filter arithmetic processing performed by the signal processing method are not explained herein because they are the same as those according to the first embodiment.

To implement the technical ideas according to the embodiments by the signal processing method, for example, the signal processing method includes: computing a plurality of first integral values corresponding to a plurality of elements in the coefficient sequence based on the first input sequence; adding a value not overlapping the first input sequence in the second input sequence to the first integral value and subtracting a value not overlapping the second input sequence in the first input sequence from the first integral value for each of the elements, thereby computing the second integral value; and computing the output signal value corresponding to the second input sequence based on the second integral value and the coefficient sequence.

To implement the technical ideas according to the embodiments by a signal processing program, the signal processing program including instructions that cause a computer to execute: adding up the first input signal throughout the filter indices for distinguishing a plurality of filter coefficients belonging to a plurality of ranges of the amplification factor for the first input signal input to the FIR filter for each of the ranges of the amplification factor, thereby computing the first integral value; adding up the product of the representative coefficient representing the filter coefficients and the first integral value computed for each of the ranges of the amplification factor throughout the set indices for distinguishing sets of the filter indices, thereby computing the first output signal value to be output from the digital filter; adding, after receiving the second input signal next to the first input signal, the second input signal shifted by the maximum filter index to the first integral value and subtracting the first input signal shifted by the minimum filter index from the first integral value for each of the ranges of the amplification factor, thereby computing the second integral value; and adding up the product of the representative coefficient and the second integral value throughout the set indices, thereby computing the second output signal value to be output from the digital filter.

To implement the technical ideas according to the embodiments by the signal processing program, for example, the signal processing program comprising instructions that cause a computer to execute: computing a plurality of first integral values corresponding to a plurality of elements in the coefficient sequence based on the first input sequence; adding a value not overlapping the first input sequence in the second input sequence to the first integral value and subtracting a value not overlapping the second input sequence in the first input sequence from the first integral value for each of the elements, thereby computing the second integral value; and computing the output signal value corresponding to the second input sequence based on the second integral value and the coefficient sequence.

The filter arithmetic processing can be performed by installing the signal processing program on a computer in the magnetic resonance imaging apparatus 100 or various signal processing servers and loading it on a memory, for example. The computer program that can cause the computer to perform the method may be stored and distributed in a storage medium, such as a magnetic disk (e.g., a hard disk), an optical disc (e.g., a CD-ROM and a DVD), and a semiconductor memory. The process and the advantageous effects of the signal processing program are not explained herein because they are the same as those according to the first embodiment.

At least one of the embodiments and the like described above can put a finite impulse response digital filter having a great number of taps to practical use.

While certain embodiments have been described, these embodiments have been presented by way of example only, and are not intended to limit the scope of the inventions. Indeed, the novel embodiments described herein may be embodied in a variety of other forms; furthermore, various omissions, substitutions and changes in the form of the embodiments described herein may be made without departing from the scope of the inventions as defined by the appended claims.

**Claims**

1. A signal processing apparatus (1) configured to compute a first integral value corresponding to an element in a coefficient sequence of a first input sequence and a second integral value corresponding to the element in a coefficient sequence of a second input sequence next to the first input sequence, the signal processing apparatus (1) comprising: an integral value computing unit (151) configured to add a value not overlapping the first input sequence in the second input sequence to the first integral value and subtract a value not overlapping the second input sequence in the first input sequence from the first integral value for the element, thereby computing the second integral value.

2. The signal processing apparatus (1) according to claim 1, further comprising a signal value computing unit (153) configured to compute an output signal value corresponding to the second input sequence based on the second integral value and the coefficient sequence of the second input sequence.

3. The signal processing apparatus (1) according to claim 2, the signal processing apparatus (1) being configured to compute a third integral value corresponding to the element in a coefficient sequence of a third input sequence next to the second input sequence, wherein

the integral value computing unit (151) configured to add a value not overlapping the second input sequence in the third input sequence to the second integral value and subtract a value not overlapping the third input sequence in the second input sequence from the second integral value for the element, thereby computing the third integral value, and
the signal value computing unit (153) configured to compute an output signal value corresponding to the third input sequence based on the third integral value and the coefficient sequence of the third input sequence.

4. The signal processing apparatus (1) according to any one of claims 1 to 3, wherein the coefficient sequence corresponds to a sequence of a series of amplification factors corresponding to an input sequence.

5. The signal processing apparatus (1) according to claim 2 or 3, wherein the integral value computing unit (151) and the signal value computing unit (153) constitute a finite impulse response digital filter.

6. The signal processing apparatus (1) according to any one of claims 1 to 5, wherein

the element is a representative coefficient representing a plurality of filter coefficients included in a range defined by values of the filter coefficients, and
the coefficient sequence is a series of the representative coefficients.

7. The signal processing apparatus (1) according to claim 6, wherein number of bits in the filter coefficients, the representative coefficient, the first integral value, and the second integral value is larger than number of bits of the first input sequence and the second input sequence.

8. The signal processing apparatus (1) according to claim 6 or 7, wherein the number of bits in the filter coefficients, the representative coefficient, the first integral value, and the second integral value is larger than 32.

9. The signal processing apparatus (1) according to any one of claims 6 to 8, wherein the range is set by comparing an arithmetic result using the filter coefficients with a threshold or comparing the filter coefficients with a threshold.

10. A magnetic resonance imaging apparatus (100) comprising:

the signal processing apparatus (1) according to any one of claims 1 to 9, wherein
the signal processing apparatus (1) configured to

use a signal value for controlling an electric current to be supplied to a gradient coil in a pulse sequence as the input sequence, and
output a position in a k-space as the output signal value, and

the magnetic resonance imaging apparatus (1) further comprises an adjusting unit (135) configured to correct a position in the k-space of magnetic resonance data generated by performing the pulse sequence or modify the pulse sequence based on the position in the k-space.

11. The signal processing apparatus (1) according to any one of claims 1 to 9, wherein the non-overlapping corresponds to delay in the input sequence.

12. The signal processing apparatus (1) according to any one of claims 1 to 9, further comprising:

a storage unit (13) configured to store therein a partial filter coefficient sequence composed of a plurality of filter coefficients arrayed in order of filter indices for distinguishing the respective filter coefficients belonging to each of a plurality of ranges of the amplification factor for the input signal input to the finite impulse response filter in units of a set index for distinguishing a set of the filter indices;
a range determining unit (31) configured to determine the range of the amplification factor of the filter coefficients determined to be included in the set of the filter indices based on the partial filter coefficient sequence corresponding to the set of the filter indices; and
a representative coefficient determining unit (32) configured to determine the representative coefficient representing the filter coefficients for each of the ranges of the amplification factor.

13. The signal processing apparatus (1) according to claim 12, wherein the representative coefficient determining unit (31) configured to compute an average of the filter coefficients for each of the ranges of the amplification factor, thereby determining the representative coefficient.

14. The signal processing apparatus (1) according to claim 12 or 13, wherein the number of bits in the filter coefficients and the representative coefficient is larger than 32.

15. A signal processing method comprising:

computing a first integral value corresponding to an element in a coefficient sequence of a first input sequence;
adding a value not overlapping the first input sequence in a second input sequence, which is next to the first input sequence, to the first integral value and subtracting a value not overlapping the second input sequence in the first input sequence from the first integral value for the element, thereby computing a second integral value corresponding to the element in a coefficient sequence of the second input sequence.

# FIG.1

NETWORK

**SIGNAL PROCESSING APPARATUS** — 1

**COMMUNICATION INTERFACE** — 11

**MEMORY** — 13

**PROCESSING CIRCUITRY** — 15

**INTEGRAL VALUE COMPUTATION FUNCTION** — 151

**SIGNAL VALUE COMPUTATION FUNCTION** — 153

**FILTER PARAMETER DETERMINING APPARATUS** — 3

**PROCESSING CIRCUITRY** — 30

**RANGE DETERMINATION FUNCTION** — 31

**REPRESENTATIVE COEFFICIENT DETERMINATION FUNCTION** — 32

**MEMORY** — 33

**RESULT OUTPUT APPARATUS** — 5

**SIGNAL INPUT APPARATUS** — 7

FIG.2

# FIG.3

FILTER INDEX SET

FILTER INDEX: INTEGER OF 0 OR LARGER (CORRESPONDING TO TIME, POSITION OF IMAGE, OR THE LIKE)

SET INDEX    0     1     2    3    4    ⋯

EP 4 020 805 A1

# FIG.4

START

INITIALIZE m TO 0 (m=0), n TO 1 (n=1), AND $D_0$ TO 0 ($D_0$={0}) — S301

DETERMINE WHETHER n-TH (0≤N<N-1) FILTER COEFFICIENT a(n) CAN BE TREATED AS FILTER COEFFICIENT HAVING SAME VALUE AS (n-1)-TH FILTER COEFFICIENT a(n-1) — S302

IF n-TH FILTER COEFFICIENT a(n) CAN BE TREATED AS FILTER COEFFICIENT HAVING SAME VALUE AS (n-1)-TH FILTER COEFFICIENT a(n-1), ADD FILTER INDEX OF n-TH FILTER COEFFICIENT a(n) TO SAME FILTER INDEX SET $D_m$ AS THAT OF (n-1)-TH FILTER COEFFICIENT — S303

IF n-TH FILTER COEFFICIENT a(n) CANNOT BE TREATED AS COEFFICIENT HAVING SAME VALUE AS (n-1)-TH FILTER COEFFICIENT a(n-1), ADD 1 TO m TO GENERATE ANOTHER FILTER INDEX SET $D_{m+1}$={n} — S304

INCREMENT n — S305

IS n≤N SATISFIED? — S306

YES

NO

COMPUTE REPRESENTATIVE COEFFICIENT $c_m$ CORRESPONDING TO FILTER INDEX SET $D_m$ — S307

OUTPUT FILTER INDEX SET AND REPRESENTATIVE COEFFICIENT TO SIGNAL PROCESSING DEVICE — S308

END

# FIG.5

AMPLIFICATION FACTOR FOR INPUT SIGNAL

PARTIAL FILTER COEFFICIENT SEQUENCE

TOTAL FILTER COEFFICIENT SEQUENCE

FILTER COEFFICIENT

REPRESENTATIVE COEFFICIENT COMPUTED FROM PARTIAL FILTER COEFFICIENT SEQUENCE

FILTER INDEX: INTEGER OF 0 OR LARGER (CORRESPONDING TO TIME, POSITION OF IMAGE, OR THE LIKE)

FILTER INDEX SET

PLURALITY OF FILTER INDEX SETS

FILTER INDEX SET

EP 4 020 805 A1

# FIG.6

| REPRESENT-ATIVE COEFFICIENT $c_m$ | DURATION LENGTH $\lvert D_m \rvert$ |
|---:|---:|
| 0.00 | 1 |
| 1.00 | 3 |
| 0.99 | 4 |
| 0.98 | 15 |
| 0.97 | 35 |
| ⋮ | ⋮ |

# FIG.7

START

S601

RESPOND TO RECEPTION OF FIRST INPUT
SIGNAL AND COMPUTE FIRST INTEGRAL VALUE
FOR EACH SET INDEX USING FIRST INPUT
SIGNAL AND FILTER INDEX SET

S602

COMPUTE FIRST OUTPUT SIGNAL VALUE USING
PLURALITY OF REPRESENTATIVE
COEFFICIENTS AND PLURALITY OF FIRST
INTEGRAL VALUES

S603

RESPOND TO INPUT OF SECOND INPUT SIGNAL
AND COMPUTE SECOND INTEGRAL VALUE FOR
EACH SET INDEX BASED ON FILTER INDEX SET,
FIRST INTEGRAL VALUE, AND SECOND INPUT
SIGNAL

S604

COMPUTE SECOND OUTPUT SIGNAL VALUE
USING PLURALITY OF REPRESENTATIVE
COEFFICIENTS AND PLURALITY OF SECOND
INTEGRAL VALUES

S605

IS NEXT INPUT
SIGNAL RECEIVED?

YES

NO

S606

COMPUTE INTEGRAL VALUE FOR EACH SET
INDEX BASED ON FILTER INDEX SET,
SECOND INTEGRAL VALUE, AND NEXT INPUT
SIGNAL AND UPDATE SECOND INTEGRAL
VALUE WITH COMPUTED INTEGRAL VALUE

S607

TRANSMIT SECOND SIGNAL OUTPUT
VALUE TO RESULT OUTPUT DEVICE

END

# FIG.8

PID

# FIG.9

NID

PID

Sub

OID

Ad

FIG.10

# FIG.11

START

S101
RESPOND TO RECEPTION OF FIRST CONTROL SIGNAL VALUE AND COMPUTE FIRST INTEGRAL VALUE FOR EACH SET INDEX USING FIRST CONTROL SIGNAL VALUE AND FILTER INDEX SET

S102
COMPUTE FIRST k-SPACE POSITION USING PLURALITY OF REPRESENTATIVE COEFFICIENTS AND PLURALITY OF FIRST INTEGRAL VALUES

S103
RESPOND TO INPUT OF SECOND CONTROL SIGNAL VALUE AND COMPUTE SECOND INTEGRAL VALUE FOR EACH SET INDEX BASED ON FILTER INDEX SET, FIRST INTEGRAL VALUE, AND SECOND CONTROL SIGNAL VALUE

S104
COMPUTE SECOND k-SPACE POSITION USING PLURALITY OF REPRESENTATIVE COEFFICIENTS AND PLURALITY OF SECOND INTEGRAL VALUES

S105
IS NEXT CONTROL SIGNAL VALUE RECEIVED?

YES

NO

S106
COMPUTE INTEGRAL VALUE FOR EACH SET INDEX BASED ON FILTER INDEX SET, SECOND INTEGRAL VALUE, AND NEXT CONTROL SIGNAL VALUE AND UPDATE SECOND INTEGRAL VALUE WITH COMPUTED INTEGRAL VALUE

S107
CORRECT POSITION IN k-SPACE IN MR DATA OR MODIFY PULSE SEQUENCE BASED ON SECOND k-SPACE POSITION

END

# FIG.12

| SUM OF INPUT SIGNALS IN $D_m$ $\left\|\sum f(t-n)\right\|$ | DURATION LENGTH $\|D_m\|$ |
|---:|---:|
| 0.000 | 1 |
| 0.030 | 3 |
| 0.110 | 4 |
| 1.125 | 15 |
| 7.000 | 35 |
| ⋮ | ⋮ |

EP 4 020 805 A1

# EP 4 020 805 A1

Europäisches
Patentamt

European
Patent Office

Office européen
des brevets

# EUROPEAN SEARCH REPORT

**Application Number**

EP 21 21 6525

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2008/133625 A1 (ALEXANDRU RADU [US]) 5 June 2008 (2008-06-05) * paragraph [0027] - paragraph [0076]; figures 1 - 7 * | 1-15 | INV. H03H17/06 H03H17/02 G01R33/565 |
| X | WO 95/24768 A1 (ANALOG DEVICES INC [US]) 14 September 1995 (1995-09-14) | 1-3,11, 15 | |
| A | * page 7, line 1 - page 13, line 8; figures 5, 6 * | 4,6-10, 12-14 | |
| X | STEVEN W SMITH ED - STEVEN W SMITH: "The Scientist & Engineer's Guide to Digital Signal Processing, Moving Average Filters", SCIENTIST AND ENGINEER'S GUIDE TO DIGITAL SIGNAL PROCESSING, CALIFORNIA TECHNICAL PUBLISHING, SAN DIEGO, CA, PAGE(S) 277 - 284 , 1 January 1997 (1997-01-01), XP002542766, ISBN: 978-0-9660176-3-2 Retrieved from the Internet: URL:http://www.dspguide.com/ [retrieved on 2009-08-24] | 1-3,11, 15 | |
| A | * Recursive Implementation; page 282 - page 284 * | 4,6-10, 12-14 | |

TECHNICAL FIELDS
SEARCHED (IPC)

H03H
G01R

-/--

The present search report has been drawn up for all claims

| Place of search | Date of completion of the search | Examiner |
|---|---|---|
| Munich | 13 May 2022 | Trafidlo, Renata |

EPO FORM 1503 03.82 (P04C01)

**page 1 of 2**

Europäisches
Patentamt

European
Patent Office

Office européen
des brevets

# EUROPEAN SEARCH REPORT

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| A | EP 0 228 056 A2 (GEN ELECTRIC [US]) 8 July 1987 (1987-07-08) * MR system; page 4, line 31 - page 8, line 6; figure 1 * * Pre-emphasis filter; page 8, line 7 - page 9, line 3; figures 2A, 2B * * Determining an impulse response of the gradient; page 12, line 3 - page 13, line 11 * * Pre-emphasis filter as a deconvolution filter; page 19, line 21 - page 20, line 5 * * Corrected gradient waveform as a convolution of a desired gradient waveform with an impulse response of pre-emphasis filter; page 21, line 11 - line 27 * | 10 | |
| A | SIGNE J. VANNESJO ET AL: "Gradient system characterization by impulse response measurements with a dynamic field camera", MAGNETIC RESONANCE IN MEDICINE, vol. 69, no. 2, 12 April 2012 (2012-04-12) , pages 583-593, XP055081659, ISSN: 0740-3194, DOI: 10.1002/mrm.24263 * THEORY AND METHODS; page 584, right-hand column - page 587, right-hand column; figure 1 * * DISCUSSION; page 589, right-hand column - page 590, right-hand column * | 10 | TECHNICAL FIELDS SEARCHED (IPC) |

The present search report has been drawn up for all claims

| Place of search | Date of completion of the search | Examiner |
|---|---|---|
| Munich | 13 May 2022 | Trafidlo, Renata |

EPO FORM 1503 03.82 (P04C01)

## ANNEX TO THE EUROPEAN SEARCH REPORT
## ON EUROPEAN PATENT APPLICATION NO.

EP 21 21 6525

This annex lists the patent family members relating to the patent documents cited in the above-mentioned European search report.
The members are as contained in the European Patent Office EDP file on
The European Patent Office is in no way liable for these particulars which are merely given for the purpose of information.

13-05-2022

| Patent document cited in search report | | | Publication date | Patent family member(s) | | | Publication date |
|---|---|---|---|---|---|---|---|
| US 2008133625 | A1 | | 05-06-2008 | CN | 101617235 | A | 30-12-2009 |
| | | | | EP | 2097759 | A2 | 09-09-2009 |
| | | | | JP | 5108022 | B2 | 26-12-2012 |
| | | | | JP | 2010512124 | A | 15-04-2010 |
| | | | | US | 8452828 | B1 | 28-05-2013 |
| | | | | US | 2008133625 | A1 | 05-06-2008 |
| | | | | WO | 2008070644 | A2 | 12-06-2008 |
| WO 9524768 | A1 | | 14-09-1995 | US | 5450083 | A | 12-09-1995 |
| | | | | WO | 9524768 | A1 | 14-09-1995 |
| EP 0228056 | A2 | | 08-07-1987 | DE | 3685947 | T2 | 18-02-1993 |
| | | | | EP | 0228056 | A2 | 08-07-1987 |
| | | | | JP | H0349453 | B2 | 29-07-1991 |
| | | | | JP | S62189057 | A | 18-08-1987 |
| | | | | US | 4698591 | A | 06-10-1987 |

EPO FORM P0459

For more details about this annex : see Official Journal of the European Patent Office, No. 12/82